# EUROPEAN PATENT APPLICATION

(11) **EP 4 797 911 A1**
(43) Date of publication of application: **26.08.2026**
(21) Application number: 24879556.9
(22) Date of filing: 01.10.2024
(51) Int. Cl.: H10F 39/12, H01L 23/12

(54) **SEMICONDUCTOR DEVICE**

(30) Priority: 18.10.2023 JP 2023179449
(71) Applicant: Sony Semiconductor Solutions Corporation, Atsugi-shi, Kanagawa 243-0014 (JP)
(72) Inventor: ARAI, Chihiro, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/035128
(87) International publication number: WO 2025/084130

(57) **Abstract**

An object is to improve heat dissipation of a semiconductor device packaged on the basis of a WLCSP while suppressing an increase in parasitic capacitance of a through electrode.

The semiconductor device includes: a first semiconductor substrate having at least one of a light-receiving layer or a circuit layer formed thereon; a support substrate on which the first semiconductor substrate is stacked, the support substrate having a thermal conductivity higher than a thermal conductivity of the first semiconductor substrate; and a through electrode extending through the support substrate to electrically connect to the first semiconductor substrate. The support substrate may have an electrical conductivity lower than that of the first semiconductor substrate. The support substrate may be an insulating substrate or a semi-insulating substrate. The semiconductor device may further include: a second semiconductor substrate having a circuit layer formed thereon, the first semiconductor substrate being stacked on the second semiconductor substrate; and an interconnect layer provided between the first semiconductor substrate and the second semiconductor substrate, and the through electrode may be electrically connected to the interconnect layer.

## Description

### TECHNICAL FIELD

The present technology relates to a semiconductor device. Specifically, the present technology relates to a semiconductor device packaged on the basis of a wafer level chip size package (WLCSP).

### BACKGROUND ART

In order to reduce the chip size, a semiconductor device may be packaged on the basis of the WLCSP. At this time, heat generated in a WLCSP-mounted chip is mainly dissipated to a mounting substrate on which the WLCSP is mounted. Here, in order to improve heat dissipation of solid semiconductor devices, a method for forming a heat dissipation path formed by a non-through hole that opens at a lower surface of a semiconductor substrate and is filled with metal has been proposed (see, for example, Patent Document 1).

### CITATION LIST

### PATENT DOCUMENT

Patent Document 1: Japanese Patent Application Laid-Open No. 2010-21451

### SUMMARY OF THE INVENTION

### PROBLEMS TO BE SOLVED BY THE INVENTION

The above-described conventional technology in which the heat dissipation path filled with metal is buried in the semiconductor substrate, however, may cause an increase in parasitic capacitance of a through electrode buried in the semiconductor substrate.

The present technology has been made in view of such circumstances, and it is therefore an object of the present technology to improve heat dissipation of a semiconductor device packaged on the basis of a WLCSP while suppressing an increase in parasitic capacitance of a through electrode.

### SOLUTIONS TO PROBLEMS

The present technology has been made to solve the above-described problems, and a first aspect of the present technology is a semiconductor device including: a first semiconductor substrate having at least one of a light-receiving layer or a circuit layer formed thereon; a support substrate on which the first semiconductor substrate is stacked, the support substrate having a thermal conductivity higher than a thermal conductivity of the first semiconductor substrate; and a through electrode extending through the support substrate to electrically connect to the first semiconductor substrate. This brings about an effect of improving the heat dissipation from the first semiconductor substrate to the support substrate.

Furthermore, in the first aspect, the support substrate may have an electrical conductivity lower than an electrical conductivity of the first semiconductor substrate. This brings about an effect of reducing the parasitic capacitance of the through electrode added via the support substrate.

Furthermore, in the first aspect, the support substrate may include an insulating substrate or a semi-insulating substrate. Since the support substrate is insulating or semi-insulating (for example, has a resistivity greater than 1E5 Ω·cm), this brings about an effect of reducing the parasitic capacitance.

Furthermore, in the first aspect, a material of the insulating substrate may include AlN, BN, or diamond. This brings about an effect of improving the thermal conductivity of the support substrate with respect to the semiconductor substrate while ensuring the insulating property of the support substrate.

Furthermore, in the first aspect, a material of the semi-insulating substrate may include GaAs, GaN, or SiC. This brings about an effect of improving the thermal conductivity of the support substrate with respect to the semiconductor substrate while reducing the electrical conductivity of the support substrate.

Furthermore, in the first aspect, the thermal conductivity of the support substrate may be greater than or equal to 150 W/(m·k). This brings about an effect of improving the heat dissipation from the first semiconductor substrate to the support substrate.

Furthermore, in the first aspect, the semiconductor device may further include: a second semiconductor substrate having a circuit layer formed thereon, the first semiconductor substrate being stacked on the second semiconductor substrate; and an interconnect layer provided between the first semiconductor substrate and the second semiconductor substrate, in which the second semiconductor substrate may be stacked on the support substrate, and the through electrode may be electrically connected to the interconnect layer. This brings about an effect of improving the heat dissipation from the first and second semiconductor substrates to the support substrate with the first semiconductor substrate stacked on the second semiconductor substrate.

Furthermore, in the first aspect, the semiconductor device may further include: a through via extending through the second semiconductor substrate to connect the through electrode and the interconnect layer; and a buried insulating layer buried in the second semiconductor substrate to insulate the through via from the second semiconductor substrate. This brings about an effect of allowing the through electrode to connect to the interconnect layer provided on the second semiconductor substrate without allowing the through electrode to extend through the second semiconductor substrate.

Furthermore, in the first aspect, the second semiconductor substrate and the support substrate may be configured by a silicon on insulator (SOI) substrate. This brings about an effect of allowing the semiconductor substrate to be formed on the insulating substrate.

Furthermore, in the first aspect, the semiconductor device may further include: an insulating layer provided between the second semiconductor substrate and the support substrate, the insulating layer including a material different from a material of the support substrate. This brings about an effect of improving controllability of over-etching during formation of through holes.

Furthermore, in the first aspect, the semiconductor device may further include: a redistribution interconnect formed on a back surface of the support substrate; and a recess or a protrusion formed in a region of the back surface of the support substrate that is not covered with the redistribution interconnect. This brings about an effect of improving the heat dissipation from the back surface side of the support substrate while allowing an external terminal to be formed on the back surface side of the support substrate.

Furthermore, in the first aspect, the semiconductor device may further include: an effective pixel region in which pixels having the light-receiving layer formed thereon are arranged in a matrix in a row direction and a column direction, in which at least a part of the through electrode may be arranged to overlap the effective pixel region. This brings about an effect of relaxing the restriction on the arrangement position of the through electrode.

Furthermore, in the first aspect, the first semiconductor substrate, the second semiconductor substrate, and the support substrate may be packaged on the basis of a wafer level chip size package (WLCSP). This brings about an effect of allowing the light-receiving layer and the circuit layer to be stacked while suppressing an increase in chip size.

Furthermore, in the first aspect, the semiconductor device may further include: an open-end terminal formed on a light-receiving surface side of the first semiconductor substrate. This brings about an effect of allowing electrical connection to the light-receiving layer from the light-receiving surface side.

Furthermore, a second aspect may be a semiconductor device including: a semiconductor substrate having a light-receiving layer formed thereon; and a transparent substrate stacked on the semiconductor substrate, the transparent substrate being provided with a transparent layer having a thermal conductivity of at least 10 W/(m·k). This brings about an effect of improving the heat dissipation from the first semiconductor substrate to the transparent substrate.

Furthermore, in the second aspect, a material of the transparent layer may include AlN, BN, or diamond. This brings about an effect of improving the thermal conductivity of the transparent substrate with respect to the semiconductor substrate while ensuring the transparency of the transparent substrate.

Furthermore, in the second aspect, the semiconductor device may further include: a light-shielding film provided on a side surface of the transparent substrate, the light-shielding film having a thermal conductivity of at least 10 W/(m·k). This brings about an effect of improving the heat dissipation from the first semiconductor substrate to the transparent substrate while reducing flare.

Furthermore, in the second aspect, a material of the light-shielding film may include a carbon nanotube. This brings about an effect of ensuring the light-shielding property while improving the thermal conductivity of the light-shielding film.

Furthermore, in the second aspect, the semiconductor device may further include: an on-chip lens formed on the light-receiving layer, the on-chip lens having a thermal conductivity of at least 10 W/(m·k) and a refractive index of at least 1.7. This brings about an effect of improving the heat dissipation from the first semiconductor substrate to the on-chip lens while ensuring the light-condensing property on the light-receiving surface.

Furthermore, in the second aspect, the semiconductor substrate and the transparent substrate may be packaged on the basis of a WLCSP. This brings about an effect of allowing the transparent substrate to be stacked on the light-receiving layer while suppressing an increase in chip size.

### BRIEF DESCRIPTION OF DRAWINGS

Fig. 1 is a cross-sectional view illustrating a configuration example of a semiconductor device according to a first embodiment.
Fig. 2 is a cross-sectional view illustrating an example of a method of manufacturing the semiconductor device according to the first embodiment.
Fig. 3 is a cross-sectional view illustrating the example of the method of manufacturing the semiconductor device according to the first embodiment.
Fig. 4 is a cross-sectional view illustrating the example of the method of manufacturing the semiconductor device according to the first embodiment.
Fig. 5 is a cross-sectional view illustrating the example of the method of manufacturing the semiconductor device according to the first embodiment.
Fig. 6 is a cross-sectional view illustrating the example of the method of manufacturing the semiconductor device according to the first embodiment.
Fig. 7 is a cross-sectional view illustrating a configuration example of a semiconductor device according to a second embodiment.
Fig. 8 is a cross-sectional view illustrating a configuration example of a semiconductor device according to a third embodiment.
Fig. 9 is a cross-sectional view illustrating an example of a method of manufacturing the semiconductor device according to the third embodiment.
Fig. 10 is a cross-sectional view illustrating the example of the method of manufacturing the semiconductor device according to the third embodiment.
Fig. 11 is a cross-sectional view illustrating the example of the method of manufacturing the semiconductor device according to the third embodiment.
Fig. 12 is a cross-sectional view illustrating a configuration example of a semiconductor device according to a fourth embodiment.
Fig. 13 is a cross-sectional view illustrating a configuration example of a semiconductor device according to a fifth embodiment.
Fig. 14 is a cross-sectional view illustrating a configuration example of a semiconductor device according to a sixth embodiment.
Fig. 15 is a cross-sectional view illustrating a configuration example of a semiconductor device according to a seventh embodiment.
Fig. 16 is a cross-sectional view illustrating a configuration example of a semiconductor device according to an eighth embodiment.
Fig. 17 is a cross-sectional view illustrating a configuration example of a semiconductor device according to a ninth embodiment.
Fig. 18 is a perspective view illustrating an example of a stacked pixel array unit according to a tenth embodiment.
Fig. 19 is a block diagram illustrating a schematic configuration example of a vehicle control system.
Fig. 20 is an explanatory diagram illustrating an example of an installation position of an imaging section.

### MODE FOR CARRYING OUT THE INVENTION

Modes for carrying out the present technology (hereinafter, referred to as embodiments) will be described below. The description will be given in the following order.
1. First Embodiment (an example in which a semiconductor substrate having a light-receiving layer formed thereon is stacked on a semiconductor substrate having a circuit layer formed thereon, a through electrode is formed in a support substrate on which the semiconductor substrate having the circuit layer formed thereon is stacked, and the thermal conductivity of the support substrate is set higher than the thermal conductivity of the semiconductor substrate having the light-receiving layer or the circuit layer formed thereon)
2. Second Embodiment (an example in which the thermal conductivity of the support substrate having the through electrode formed therein is set higher than the thermal conductivity of the semiconductor substrate having the light-receiving layer or circuit layer formed thereon, and a recess is provided on the back surface side of the support substrate)
3. Third Embodiment (an example in which a transparent substrate is stacked on the light-receiving layer formed on the semiconductor substrate, and a light-shielding film having a thermal conductivity of at least 10 W/(m·k) is provided on the side surfaces of the transparent substrate)
4. Fourth Embodiment (an example in which the through electrode is formed in the support substrate on which the semiconductor substrate having the circuit layer formed thereon is stacked, the through electrode extends through the semiconductor substrate, and the thermal conductivity of the support substrate is set higher than the thermal conductivity of the semiconductor substrate having the light-receiving layer or the circuit layer formed thereon)
5. Fifth Embodiment (an example in which the through electrode is formed in the support substrate on which the semiconductor substrate having the circuit layer formed thereon is stacked, the through electrode extends through an interconnect layer provided on the semiconductor substrate, and the thermal conductivity of the support substrate is set higher than the thermal conductivity of the semiconductor substrate having the light-receiving layer or the circuit layer formed thereon)
6. Sixth Embodiment (an example in which the through electrode is formed in the support substrate on which the semiconductor substrate having the circuit layer formed thereon is stacked, the through electrode is arranged to overlap an effective pixel region, and the thermal conductivity of the support substrate is set higher than the thermal conductivity of the semiconductor substrate having the light-receiving layer or the circuit layer formed thereon)
7. Seventh Embodiment (an example in which the through electrode is formed in the support substrate on which the semiconductor substrate having the circuit layer formed thereon is stacked, an open-end terminal is formed on the light-receiving surface side, and the thermal conductivity of the support substrate is set higher than the thermal conductivity of the semiconductor substrate having the light-receiving layer or the circuit layer formed thereon)
8. Eighth Embodiment (an example in which the transparent substrate is stacked on the light-receiving layer formed on the semiconductor substrate, and a transparent layer having a thermal conductivity of at least 10 W/(m·k) is provided on the transparent substrate)
9. Ninth Embodiment (an example in which the through electrode is formed in the support substrate on which the semiconductor substrate having the light-receiving layer formed thereon is stacked, and the thermal conductivity of the support substrate is set higher than the thermal conductivity of the semiconductor substrate having the light-receiving layer or the circuit layer formed thereon)
10. Tenth Embodiment (an example of a stacked pixel array unit)
11. Application Examples to Mobile Object

### <1. First Embodiment>

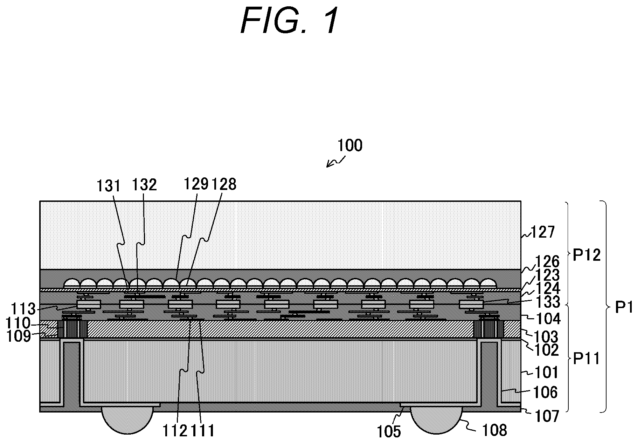

Fig. 1 is a diagram illustrating a configuration example of a semiconductor device according to a first embodiment. Note that in the drawings used in the following description, a scale, a shape, and the like may be different from those of an actual structure in order to facilitate understanding of each configuration.

In this drawing, a semiconductor device 100 includes a stacked chip P1. The stacked chip P1 includes a circuit chip P11 and a sensor chip P12. The sensor chip P12 is stacked on the circuit chip P11. Here, the planar size and shape of the circuit chip P11 can be made equal to the planar size and shape of the sensor chip P12. At this time, the ends of the circuit chip P11 in the horizontal direction can be aligned with the ends of the sensor chip P12 in the horizontal direction. This allows the stacked chip P1 to constitute a wafer level chip size package (WLCSP) that is packaged at the wafer level.

On the sensor chip P12, a light-receiving layer is formed. In the light-receiving layer, a light-receiving element is formed. The light-receiving element may be a photoelectric conversion element. The photoelectric conversion element may be an image sensor such as a complementary metal-oxide semiconductor (CMOS) sensor or a single photon avalanche diode (SPAD) sensor. The image sensor may be a back-illuminated image sensor. The light received by the image sensor may be visible light, near infrared light (NIR), short wavelength infrared light (SWIR), ultraviolet light, X-rays, or the like.

For example, the sensor chip P12 can be provided with a pixel region. In the pixel region, pixels are arranged in a matrix along the row and column directions. In each pixel, a photodiode and a pixel transistor can be formed. The pixel transistor may include a reset transistor that resets the pixel, a selection transistor that selects the pixel, a transfer transistor that transfers charge accumulated in the pixel, and an amplifier transistor that forms a source follower with the pixel.

The sensor chip P12 includes a semiconductor substrate 123. On the pixel region of the semiconductor substrate 123, a color filter 128 is formed for each pixel. On the color filter 128, an on-chip lens 129 is formed for each pixel. As the materials of the color filter 128 and the on-chip lens 129, for example, an insulating film such as SiO₂, SiN, or SiCN, or a transparent resin such as acrylic or polycarbonate can be used. The color filter 128 may include a pigment. For example, the color filter 128 may form a Bayer array or a quad-Bayer array. The color filter 128 may include an RGB filter, a complementary color filter, or a white filter.

Note that the material of the on-chip lens 129 may be a transparent material having a thermal conductivity of at least 10 W/(m·k). At this time, the refractive index of the on-chip lens 129 may be higher than the refractive index of an adhesive layer 126. For example, the refractive index of the on-chip lens 129 can be greater than or equal to 1.7. Examples of the material of the on-chip lens 129 may include AlN, BN, and diamond. As the method of forming the on-chip lens 129 using such a hard material, with a lens-shaped resin mask formed on a lens material, the lens shape of the resin mask may be transferred to the lens material by etching the lens material through the resin mask. Nanoimprinting may be used to form the lens-shaped resin mask.

Here, the photodiode can be arranged on the back surface side of the semiconductor substrate 123. A gate electrode buried in an insulating layer is formed on the front surface side of the semiconductor substrate 123. At this time, in the semiconductor substrate 123, a channel region located under the gate electrode and impurity diffusion layers located on both sides of the channel region can be formed.

A transparent substrate 127 is bonded to the back surface side of the semiconductor substrate 123 with the adhesive layer 126 interposed therebetween. The transparent substrate 127 can seal the pixel region of the sensor chip P12. At this time, the adhesive layer 126 can cover the on-chip lens 129.

As the material of the adhesive layer 126, a transparent resin such as a siloxane-based resin, an acrylic-based resin, or an epoxy-based resin can be used. At this time, the material of the adhesive layer 126 can be selected so as to ensure a refractive index difference with the on-chip lens 129. The adhesive layer 126 may contain a filler including an inorganic or organic material in order to improve reliability. As the material of the adhesive layer 126, a resin material having adjusted optical properties (such as a refractive index and an extinction coefficient) may be selected so as to allow the effective pixel region to receive light efficiently.

The transparent substrate 127 may be a glass substrate, a quartz substrate, or a transparent resin substrate such as acrylic or polycarbonate. For the transparent substrate 127, Al₂O₃, CaF₂, MgF₂, LiF, or the like may be used according to a wavelength detected by an optical element formed in the sensor chip P12. The material of the transparent substrate 127, however, can be selected so as to ensure a refractive index difference with the on-chip lens 129.

Note that, as the material of the transparent substrate 127, a transparent material having a thermal conductivity of at least 10 W/(m·k) may be used in order to improve heat dissipation through the transparent substrate 127. Examples of the material of the transparent substrate 127 may include AlN, BN, and diamond.

On the semiconductor substrate 123, an interconnect layer 124 is formed. The interconnect layer 124 is provided with an interconnect 131 and a bonding electrode 133 that are buried in an insulating layer. The interconnect layer 124 is further provided with a via 132 used for interlayer connection. The bonding electrode 133 can be used for direct bonding between the sensor chip P12 and the circuit chip P11.

On the circuit chip P11, a circuit layer is formed. In the circuit layer, a semiconductor element is formed. The semiconductor element may include a transistor, a resistor, a capacitor, and the like. As the semiconductor element, a memory may be formed, a processor may be formed, a signal processing circuit may be formed, a data processing circuit may be formed, or an interface circuit may be formed. As the semiconductor element, for example, a hardware circuit such as a field-programmable gate array (FPGA) or an application specific integrated circuit (ASIC) may be formed.

The circuit chip P11 includes a support substrate 101 and a semiconductor substrate 103. On the front surface side of the semiconductor substrate 103, a gate electrode buried in an insulating layer is formed. At this time, in the semiconductor substrate 103, a channel region located under the gate electrode and impurity diffusion layers located on both sides of the channel region can be formed.

Furthermore, in the semiconductor substrate 103, a buried insulating layer 109 is buried. The buried insulating layer 109 may be a full-thickness deep trench isolation (FTI). In the buried insulating layer 109, a through via 110 is buried. A plurality of the through vias 110 may be buried in each buried insulating layer 109. The buried insulating layer 109 can be arranged to overlap a through electrode 106. At this time, the through via 110 is connected to the through electrode 106. Here, burying the through via 110 in the buried insulating layer 109 makes it possible to improve dielectric withstand voltage between the through via 110 and the semiconductor substrate 103.

On the semiconductor substrate 103, an interconnect layer 104 is formed. The interconnect layer 104 is provided with an interconnect 111 and a bonding electrode 113 that are buried in an insulating layer. The interconnect layer 104 is further provided with a via 112 used for interlayer connection. The bonding electrode 113 can be used for direct bonding between the sensor chip P12 and the circuit chip P11. For the direct bonding between the sensor chip P12 and the circuit chip P11, hybrid bonding can be used. At this time, the bonding electrodes 113 and 133 are arranged to face each other. Then, the bonding electrodes 113 and 133 can be bonded to each other on the basis of metal bonding such as Cu-Cu bonding.

The semiconductor substrate 103 is stacked on the support substrate 101. The thermal conductivity of the support substrate 101 can be set higher than the thermal conductivity of at least one of the semiconductor substrates 103 and 123. For example, the thermal conductivity of the support substrate 101 is preferably higher than the thermal conductivity of at least one of the semiconductor substrates 103 and 123 that generates a larger amount of heat. At this time, the thermal conductivity of the support substrate 101 is preferably greater than or equal to 150 W/(m·k). Furthermore, the electrical conductivity of the support substrate 101 can be set lower than the electrical conductivity of at least one of the semiconductor substrates 103 and 123.

Note that it is preferable to satisfy both a first condition that the thermal conductivity of the support substrate 101 is higher than the thermal conductivity of at least one of the semiconductor substrates 103 and 123 and a second condition that the electrical conductivity of the support substrate 101 is lower than the electrical conductivity of at least one of the semiconductor substrates 103 and 123. It is, however, not necessarily required to satisfy both the first condition and the second condition, and it is sufficient to satisfy either the first condition or the second condition.

Between the semiconductor substrate 103 and the support substrate 101, an insulating layer 102 may be provided. The material of the insulating layer 102 can be different from the material of the support substrate 101. At this time, the insulating layer 102 can be used as an etch stop layer during formation of a through hole through which the through electrode 106 extends. The semiconductor substrate 103 and the support substrate 101 may include a silicon on insulator (SOI) substrate.

The through electrode 106 is buried in the support substrate 101. The through electrode 106 extends to the buried insulating layer 109 to connect to the through via 110. On the back surface side of the support substrate 101, a redistribution interconnect 105 is formed. The redistribution interconnect 105 is connected to the through electrode 106. The inner surface of the through electrode 106 and the redistribution interconnect 105 are covered with an insulating layer 107. The redistribution interconnect 105 is connected to a bump electrode 108 through the insulating layer 107. The through electrode 106 and the redistribution interconnect 105 may be formed by the same thin film or may be formed integrally. The bump electrode 108 may be, for example, a solder ball or a pillar electrode.

Examples of the material of each of the semiconductor substrates 103 and 123 may include Si, GaAs, SiC, GaN, InGaAs, InP, and the like. The materials of the semiconductor substrates 103 and 123 may be the same or different.

The support substrate 101 may be an insulating substrate or a semi-insulating substrate. The semi-insulating substrate may be, for example, an undoped semiconductor substrate. Examples of the material of the insulating substrate include AlN, BN, and diamond. Examples of the material of the semi-insulating substrate include GaAs, GaN, and SiC.

As the material of the insulating layer used for each of the interconnect layers 104 and 124, for example, SiO₂, SiN, or SiCN can be used. The material of the insulating layer 107 may be a resin such as solder resist, or an inorganic material such as SiO₂, SiN, or SiCN. As the materials of the interconnects 111 and 131, the redistribution interconnect 105, the vias 112 and 132, and the bonding electrodes 113 and 133, for example, a metal such as Al, Cu, AlCu, AlSiCu, or Co can be used. As the material of the through electrode 106, for example, a metal such as Cu, Ti, Ta, Al, W, Ni, Ru, or Co can be used; alternatively, a stacked structure including a plurality of materials may be used. The material of the through electrode 106 and the material of the redistribution interconnect 105 may be the same.

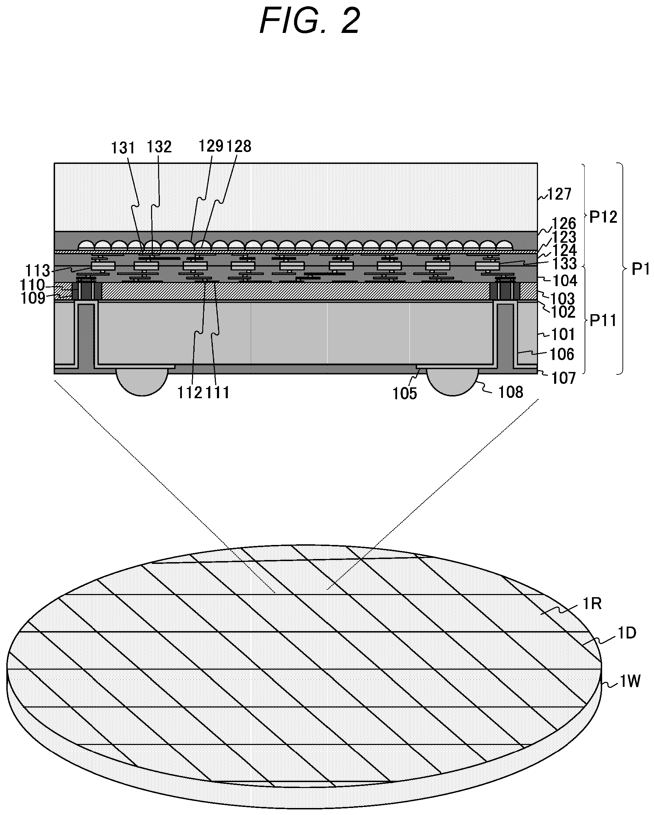

Figs. 2 to 6 are cross-sectional views illustrating an example of a method of manufacturing the semiconductor device according to the first embodiment.

In Fig. 2, a stacked wafer 1W includes partition regions 1R. The partition regions 1R are partitioned along scribe lines 1D. The stacked chip P1 is cut out from each partition region 1R. At this time, the stacked wafer 1W can be cut along the scribe lines 1D into individual stacked chips P1, which are packaged on the basis of the WLCSP.

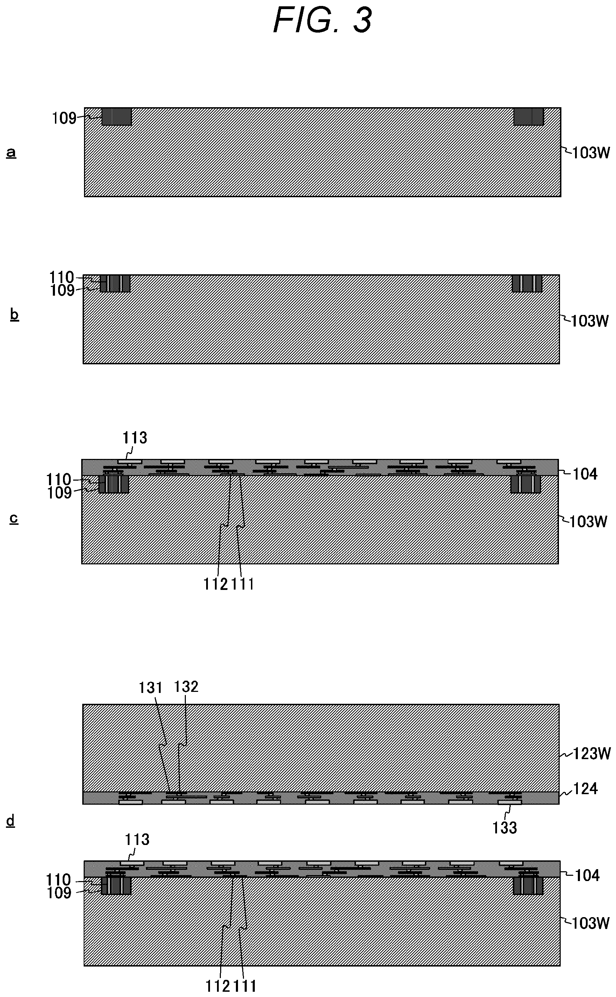

In the formation of the stacked wafer 1W, for example, as illustrated in a of Fig. 3, the buried insulating layer 109 is buried in a semiconductor wafer 103W. At this time, the entire surface can be planarized from the buried insulating layer 109 across the semiconductor wafer 103W. For example, after the buried insulating layer 109 buried in the semiconductor wafer 103W is deposited over the entire surface of the semiconductor wafer 103W, the buried insulating layer 109 may be thinned by a method such as CMP until the front surface of the semiconductor wafer 103W is exposed.

Next, as illustrated in b of Fig. 3, the through via 110 is buried in the buried insulating layer 109. A plurality of the through vias 110 may be buried in each buried insulating layer 109. At this time, the entire surface can be planarized from the through via 110 across the semiconductor wafer 103W in which the buried insulating layer 109 is buried.

Next, as illustrated in c of Fig. 3, a circuit layer is formed on the semiconductor wafer 103W for each partition region 1R, and the interconnect layer 104 is formed on the semiconductor wafer 103W.

Next, as illustrated in d of Fig. 3, a light-receiving layer is formed on a semiconductor wafer 123W for each partition region 1R, and the interconnect layer 124 is formed on the semiconductor wafer 123W. Then, the semiconductor wafers 103W and 123W are positioned such that the interconnect layers 104 and 124 face each other.

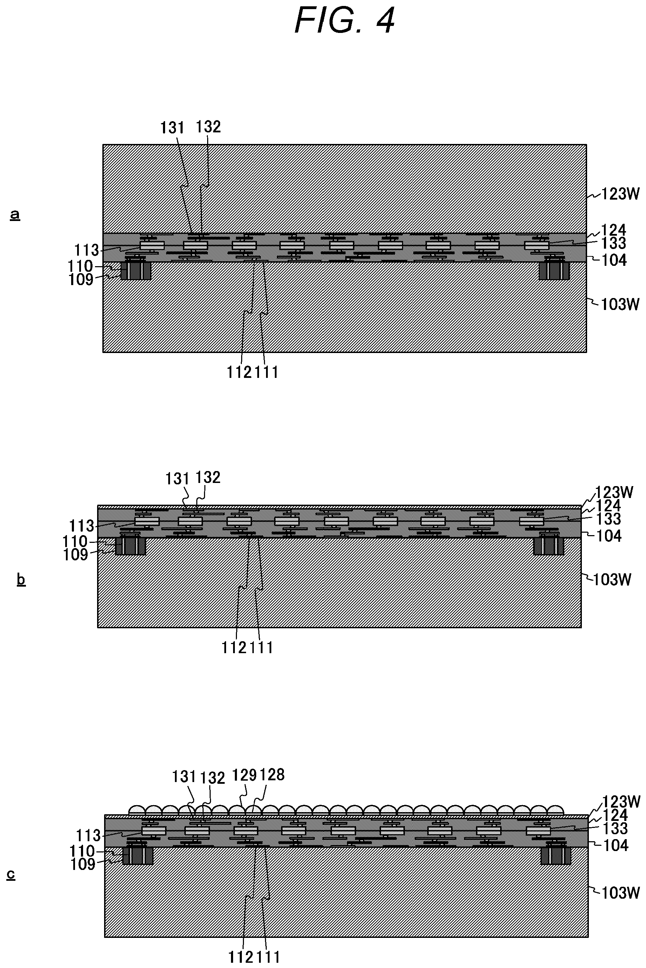

Next, as illustrated in a of Fig. 4, the semiconductor wafers 103W and 123W are directly bonded to each other. For the direct bonding between the semiconductor wafers 103W and 123W, hybrid bonding can be used. At this time, the bonding electrodes 113 and 133 are arranged to face each other. Then, the bonding electrodes 113 and 133 can be bonded to each other on the basis of metal bonding such as Cu-Cu bonding.

Next, as illustrated in b of Fig. 4, the semiconductor wafer 123W is thinned from the back surface side by a method such as chemical mechanical polishing (CMP). At this time, a light-receiving surface is formed on the back surface of the semiconductor wafer 123W.

Next, as illustrated in c of Fig. 4, the color filter 128 is formed on the back surface of the semiconductor wafer 123W for each pixel. Furthermore, the on-chip lens 129 is formed on the color filter 128 for each pixel.

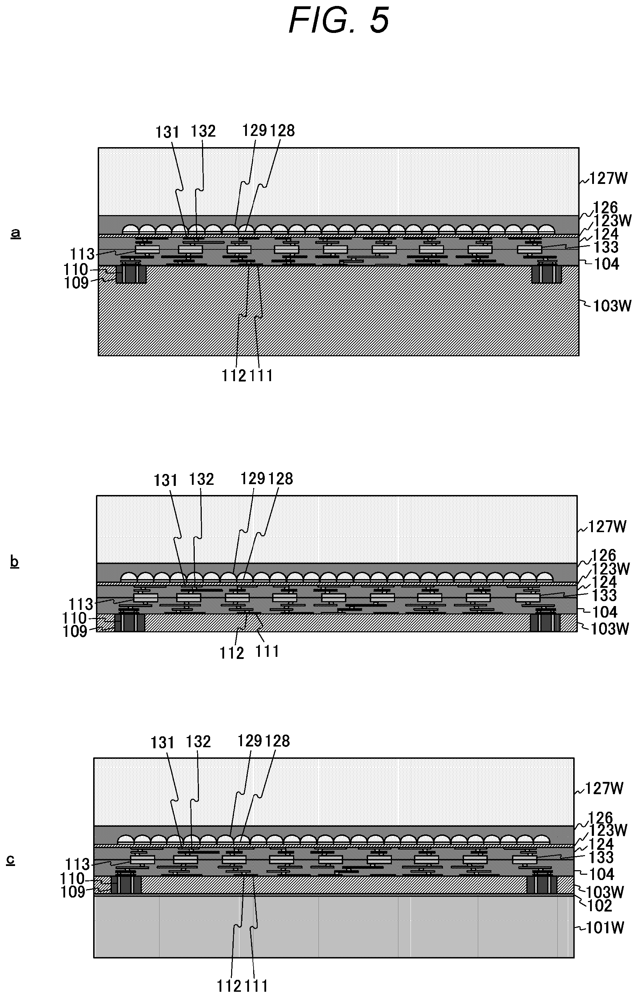

Next, as illustrated in a of Fig. 5, a transparent substrate wafer 127W is bonded to the semiconductor wafer 123W with the adhesive layer 126 interposed therebetween. At this time, the on-chip lens 129 can be covered with the adhesive layer 126.

Next, as illustrated in b of Fig. 5, the semiconductor wafer 103W is thinned from the back surface side by a method such as CMP until the through via 110 is exposed. At this time, a bonding surface to be bonded to a support substrate wafer 101W is formed on the back surface of the semiconductor wafer 103W.

Next, as illustrated in c of Fig. 5, the insulating layer 102 is formed on the back surface side of the semiconductor wafer 103W by a method such as plasma chemical vapor deposition (CVD) or sputtering. Next, the support substrate wafer 101W is bonded to the back surface side of the semiconductor wafer 103W with the insulating layer 102 interposed therebetween. This bonding may be achieved, for example, by pressure bonding at 250°C or below with the bonding surfaces plasma-activated.

The plasma activation can introduce SiO₂ into the bonding surfaces. At this time, oxygen plasma or nitrogen plasma can be applied to the bonding surfaces to hydrophilize the bonding surfaces. Then, the bonding surfaces can be brought into intimate contact on the basis of hydrogen bonding between OH groups formed on the bonding surfaces as a result of adsorption of moisture from the air. Then, the OH groups are decomposed by heat treatment, and the resultant hydrogen is diffused into the interface layer, thereby achieving direct bonding based on Si-O-Si bonding mediated by oxygen. Here, the plasma activation performed on the bonding surfaces before the heat treatment can improve the moisture adsorption of the bonding surfaces, thereby achieving a bonding strength required to ensure the reliability of the solid-state imaging device even with heat treatment at 250°C or below.

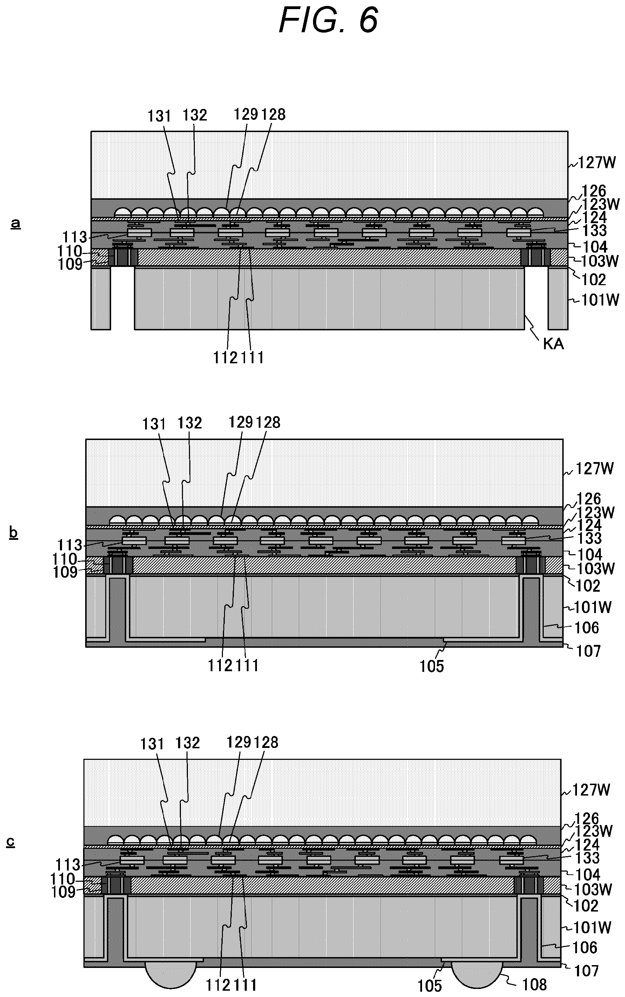

Next, as illustrated in a of Fig. 6, a through hole KA is formed in the support substrate wafer 101W on the basis of a lithography technique and a dry etching technique. The through hole KA extends through the support substrate wafer 101W and the insulating layer 102 to allow the through via 110 to be exposed. In the dry etching of the support substrate wafer 101W, for example, reactive ion etching (RIE) can be used. At this time, the insulating layer 102 can be used as an etch stop film during the formation of the through hole KA. Here, the through via 110 provided in the semiconductor wafer 103W eliminates the need for penetrating the semiconductor wafer 103W through the through hole KA. It is therefore possible to eliminate the need for switching etching gases and the like for forming the through hole KA, thereby facilitating the formation of the through hole KA.

Next, as illustrated in b of Fig. 6, the through electrode 106 is formed along the inner surface of the through hole KA, and the redistribution interconnect 105 is formed on the back surface side of the support substrate wafer 101W. Then, the insulating layer 107 is formed on the back surface side of the support substrate wafer 101W so as to fill the inside of the through electrode 106 and cover the redistribution interconnect 105.

Next, as illustrated in c of Fig. 6, the bump electrode 108 that is connected to the redistribution interconnect 105 through the insulating layer 107 is formed on the back surface side of the support substrate wafer 101W. At this time, the stacked wafer 1W illustrated in Fig. 2 is formed.

Next, as illustrated in Fig. 1, the stacked wafer 1W is cut along the scribe lines 1D into individual stacked chips P1.

As described above, in the first embodiment, the through electrode 106 is formed in the support substrate 101 on which the semiconductor substrate 103 having the circuit layer formed thereon is stacked, and the thermal conductivity of the support substrate 101 is set higher than the thermal conductivity of at least one of the semiconductor substrates 103 and 123. This configuration can improve heat dissipation from the semiconductor substrates 103 and 123 to the support substrate 101 and suppress a decrease in reliability while downsizing the stacked chip P1 on the basis of the WLCSP.

Furthermore, the support substrate 101 is an insulating substrate or a semi-insulating substrate. With this configuration, the support substrate 101 is insulating or semi-insulating (for example, has a resistivity greater than 1E5 Ω·cm); therefore, it is possible to reduce the parasitic capacitance of the through electrode 106 added via the support substrate 101. As a result, it is possible to reduce the size of the stacked chip P1 on the basis of the WLCSP and to suppress deterioration of high-frequency characteristics.

### <2. Second Embodiment>

In the first embodiment described above, the through electrode 106 is formed in the support substrate 101 on which the semiconductor substrate 103 having the circuit layer formed thereon is stacked, and the thermal conductivity of the support substrate 101 is set higher than the thermal conductivity of at least one of the semiconductor substrates 103 and 123. In this second embodiment, the thermal conductivity of the support substrate having the through electrode 106 formed therein is set higher than the thermal conductivity of at least one of the semiconductor substrates 103 and 123, and a recess is provided on the back surface side of the support substrate.

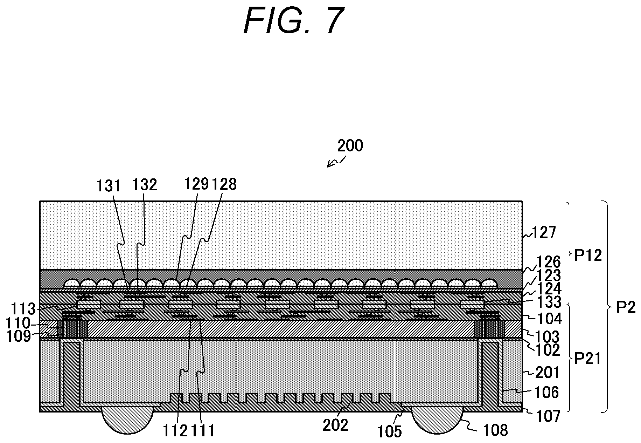

Fig. 7 is a diagram illustrating a configuration example of a semiconductor device according to the second embodiment.

In the drawing, a semiconductor device 200 includes a stacked chip P2 instead of the stacked chip P1 of the first embodiment described above. The stacked chip P2 includes a circuit chip P21 instead of the circuit chip P11 of the first embodiment described above. The other configurations of the semiconductor device 200 of the second embodiment are similar to those of the semiconductor device 100 of the first embodiment described above.

On the circuit chip P21, the sensor chip P12 is stacked. The circuit chip P21 includes a support substrate 201 instead of the support substrate 101 of the first embodiment described above. On the back surface side of the support substrate 201, a recess 202 is formed. On the back surface side of the support substrate 201, a protrusion may be formed instead of the recess 202. The recess 202 can be formed in a region excluding the lower portion of the bump electrode 108. For example, the recess 202 may be formed in a region that is not covered by the redistribution interconnect 105 on the back surface side of the support substrate 201. The recess 202 can increase a heat dissipation area on the back surface side of the support substrate 201. The other configurations of the circuit chip P21 of the second embodiment are similar to those of the circuit chip P11 of the first embodiment described above.

As described above, in the second embodiment, the thermal conductivity of the support substrate 201 having the through electrode 106 formed therein is set higher than the thermal conductivity of at least one of the semiconductor substrates 103 and 123, and the recess 202 is provided on the back surface side of the support substrate 201. This configuration can improve heat dissipation from the semiconductor substrate 123 having the light-receiving layer formed thereon to the support substrate 201 and suppress a decrease in reliability while downsizing the stacked chip P2 on the basis of the WLCSP.

### <3. Third Embodiment>

In the first embodiment described above, the through electrode 106 is formed in the support substrate 101 on which the semiconductor substrate 103 having the circuit layer formed thereon is stacked, and the thermal conductivity of the support substrate 101 is set higher than the thermal conductivity of at least one of the semiconductor substrates 103 and 123. In this third embodiment, a transparent substrate is stacked on the light-receiving layer formed on the semiconductor substrate 123, and a light-shielding film having a thermal conductivity of at least 10 W/(m·k) is provided on the side surfaces of the transparent substrate.

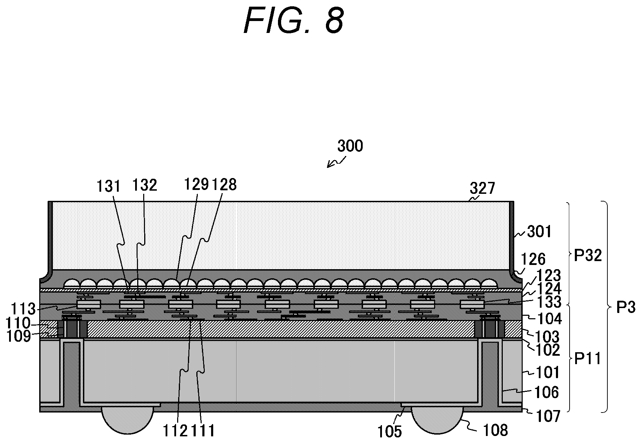

Fig. 8 is a diagram illustrating a configuration example of a semiconductor device according to the third embodiment.

In the drawing, a semiconductor device 300 includes a stacked chip P3 instead of the stacked chip P1 of the first embodiment described above. The stacked chip P3 includes a sensor chip P32 instead of the sensor chip P12 of the first embodiment described above. The other configurations of the semiconductor device 300 of the third embodiment are similar to those of the semiconductor device 100 of the first embodiment described above.

The sensor chip P32 is stacked on the circuit chip P11. The sensor chip P32 includes a transparent substrate 327 instead of the transparent substrate 127 of the first embodiment described above. The planar size of the transparent substrate 327 can be set smaller than the planar size of the semiconductor substrate 103. At this time, the ends of the transparent substrate 327 in the horizontal direction can be set back from the ends of the semiconductor substrate 103 in the horizontal direction. Note that the planar size of the transparent substrate 327 may be set larger than the planar size of the semiconductor substrate 103. On the side surfaces of the transparent substrate 327, a light-shielding film 301 is formed. The thermal conductivity of the light-shielding film 301 can be greater than or equal to 10 W/(m·k). At this time, the light-shielding film 301 can improve heat dissipation from the side surfaces of the transparent substrate 327. Examples of the material of the light-shielding film 301 may include a carbon nanotube. The light-shielding film 301 may cover all or part of the side surfaces of the transparent substrate 327. The light-shielding film 301 may extend into the adhesive layer 126, may cover the side surfaces of the semiconductor substrate 123, may cover the side surfaces of the semiconductor substrate 103, or may reach the front surface of the support substrate 101. The other configurations of the sensor chip P32 of the third embodiment are similar to those of the sensor chip P12 of the first embodiment described above.

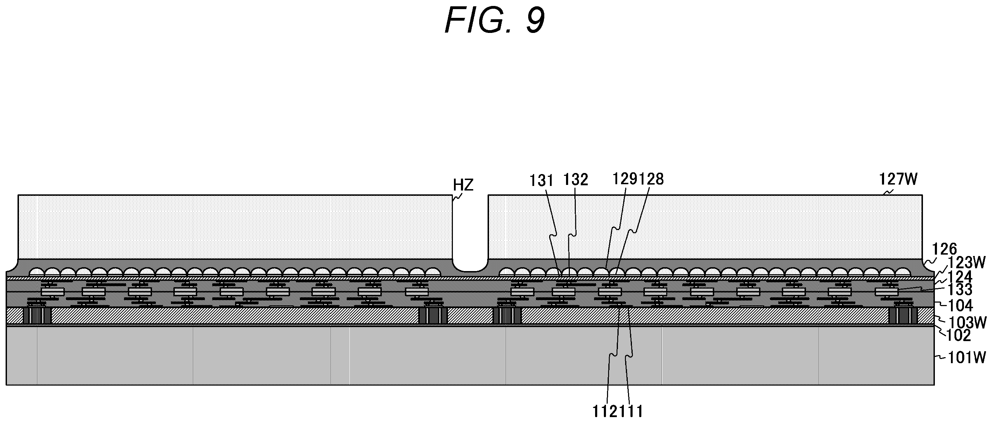

Figs. 9 to 11 are cross-sectional views illustrating an example of a method of manufacturing the semiconductor device according to the third embodiment.

The method of manufacturing the semiconductor device according to the third embodiment is obtained by adding a half-cut process, deposition of a light-shielding film, and CMP to the method of manufacturing the semiconductor device according to the first embodiment described above.

For example, after the process of c of Fig. 5, as illustrated in Fig. 9, the transparent substrate wafer 127W is half-cut along the scribe lines 1D to form a groove HZ in the transparent substrate wafer 127W. The depth of the groove HZ may be larger than or equal to the thickness of the transparent substrate wafer 127W. The depth of the groove HZ may be set, as appropriate, to reach the front surface of the support substrate 101. The groove HZ may extend into the support substrate 101 to an extent sufficient to hold the support substrate 101. The groove HZ may be formed by dicing or laser irradiation.

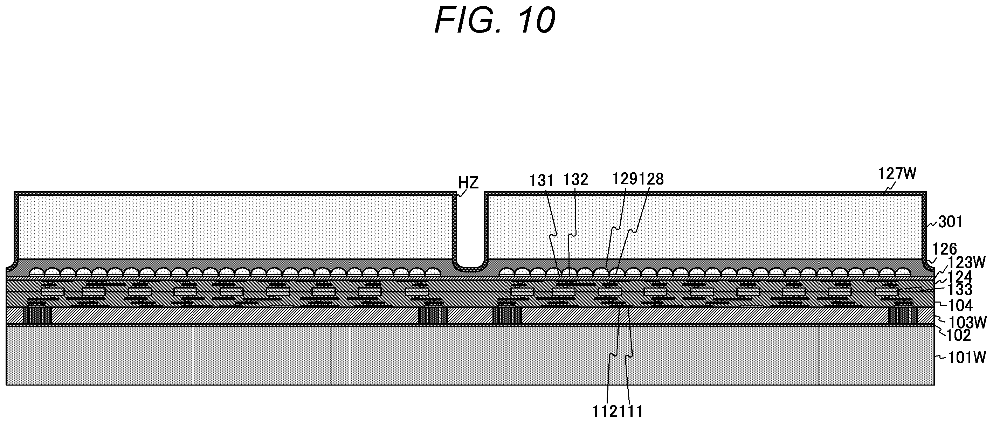

Next, as illustrated in Fig. 10, the light-shielding film 301 is formed on the transparent substrate wafer 127W so as to cover the inner surface of the groove HZ by a method such as CVD, sputtering, or spray coating. In the groove HZ, the light-shielding film 301 can be formed along the inner surface of the groove HZ.

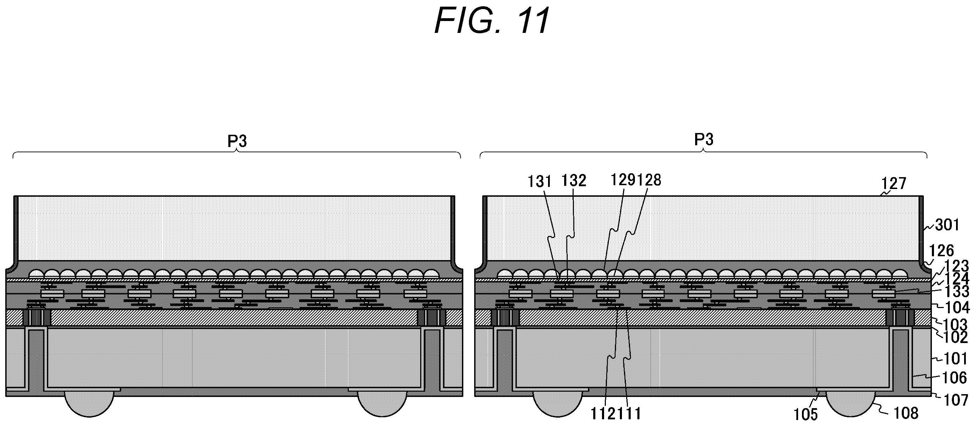

Next, after the processes of a to c of Fig. 6, as illustrated in Fig. 11, the transparent substrate wafer 127W is fully cut along the scribe lines 1D into individual stacked chips P3.

As described above, in the third embodiment, the transparent substrate 327 is stacked on the light-receiving layer formed on the semiconductor substrate 123, and the light-shielding film 301 having a thermal conductivity of at least 10 W/(m·k) is provided on the side surfaces of the transparent substrate 327. This configuration can improve heat dissipation from the semiconductor substrate 123 having the light-receiving layer formed thereon to the transparent substrate 327 and suppress a decrease in reliability while downsizing the stacked chip P3 on the basis of the WLCSP.

Note that the structure in which the light-shielding film 301 of the third embodiment described above is provided on the side surfaces of the transparent substrate 327 may be applied to the semiconductor device of the second embodiment described above.

### <4. Fourth Embodiment>

In the first embodiment described above, the through electrode 106 is formed in the support substrate 101 on which the semiconductor substrate 103 having the circuit layer formed thereon is stacked. In this fourth embodiment, a through electrode is formed in the support substrate 101 on which the semiconductor substrate 103 having the circuit layer formed thereon is stacked so as to extend through the semiconductor substrate 103.

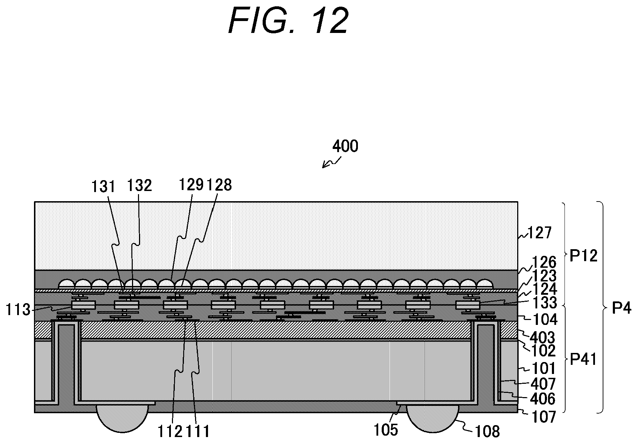

Fig. 12 is a diagram illustrating a configuration example of a semiconductor device according to the fourth embodiment.

In the drawing, a semiconductor device 400 includes a stacked chip P4 instead of the stacked chip P1 of the first embodiment described above. The stacked chip P4 includes a circuit chip P41 instead of the circuit chip P11 of the first embodiment described above. The other configurations of the semiconductor device 400 of the fourth embodiment are similar to those of the semiconductor device 100 of the first embodiment described above.

The circuit chip P41 includes a semiconductor substrate 403 and a through electrode 406 instead of the semiconductor substrate 103 and the through electrode 106 of the first embodiment described above. The buried insulating layer 109 and the through via 110 of the first embodiment described above are removed from the semiconductor substrate 403. The through electrode 406 extends through the support substrate 101, the insulating layer 102, and the semiconductor substrate 403 to connect to the interconnect 111. At this time, the through electrode 406 is insulated from the semiconductor substrate 403 via an insulating layer 407. The other configurations of the circuit chip P41 of the fourth embodiment are similar to those of the circuit chip P11 of the first embodiment described above.

As described above, in the fourth embodiment, the through electrode 406 is formed in the support substrate 101 on which the semiconductor substrate 103 having the circuit layer formed thereon is stacked so as to extend through the semiconductor substrate 103. This configuration eliminates the need for providing the through via 110 insulated from the semiconductor wafer 103W in the semiconductor wafer 103W, and thus can reduce the number of processes required to manufacture the circuit chip P41.

Note that the structure of the through electrode 406 of the fourth embodiment described above may be applied to the semiconductor device of either the second or third embodiment described above.

### <5. Fifth Embodiment>

In the fourth embodiment described above, the through electrode 406 is formed in the support substrate 101 on which the semiconductor substrate 103 having the circuit layer formed thereon is stacked so as to extend through the semiconductor substrate 103. In this fifth embodiment, a through electrode is formed in the support substrate 101 on which the semiconductor substrate 103 having the circuit layer formed thereon is stacked so as to extend through the interconnect layer provided on the semiconductor substrate 103.

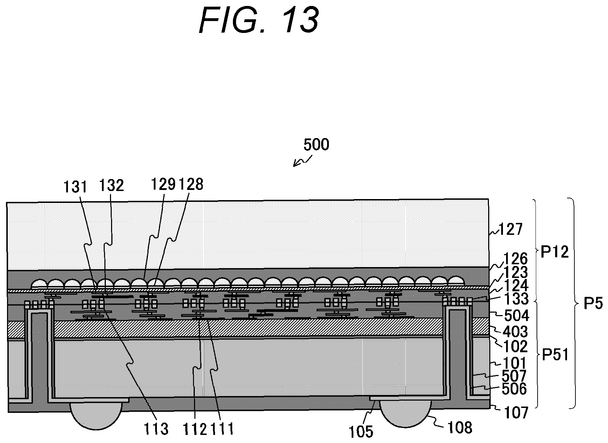

Fig. 13 is a diagram illustrating a configuration example of a semiconductor device according to the fifth embodiment.

In the drawing, a semiconductor device 500 includes a stacked chip P5 instead of the stacked chip P4 of the fourth embodiment described above. The stacked chip P5 includes a circuit chip P51 instead of the circuit chip P41 of the fourth embodiment described above. The other configurations of the semiconductor device 500 of the fifth embodiment are similar to those of the semiconductor device 400 of the fourth embodiment described above.

The circuit chip P51 includes an interconnect layer 504 and a through electrode 506 instead of the interconnect layer 104 and the through electrode 406 of the fourth embodiment described above. The through electrode 506 extends through the support substrate 101, the insulating layer 102, the semiconductor substrate 403, and the interconnect layer 504 to connect to the bonding electrode 113. At this time, the through electrode 506 is insulated from the semiconductor substrate 403 via an insulating layer 507. Note that the bonding electrode 113 to which the through electrode 506 is connected may be a single electrode or may be divided into a plurality of electrodes. From the interconnect layer 504, the interconnect 111 and the via 112 that coincide in position with the through electrode 506 are removed. The other configurations of the circuit chip P51 of the fifth embodiment are similar to those of the circuit chip P41 of the fourth embodiment described above.

As described above, in the fifth embodiment, the through electrode 506 is formed in the support substrate 101 on which the semiconductor substrate 103 having the circuit layer formed thereon is stacked so as to extend through the interconnect layer 504 provided on the semiconductor substrate 103. This configuration can directly connect the through electrode 506 to the sensor chip P12, and thus can shorten the connection path from the sensor chip P12 to an external terminal.

Note that the structure of the through electrode 506 of the fifth embodiment described above may be applied to the semiconductor device of either the second or third embodiment described above.

### <6. Sixth Embodiment>

In the first embodiment described above, the through electrode 406 is formed in the support substrate 101 on which the semiconductor substrate 103 having the circuit layer formed thereon is stacked. In this sixth embodiment, a through electrode is formed in the support substrate 101 on which the semiconductor substrate 103 having the circuit layer formed thereon is stacked so as to overlap the effective pixel region.

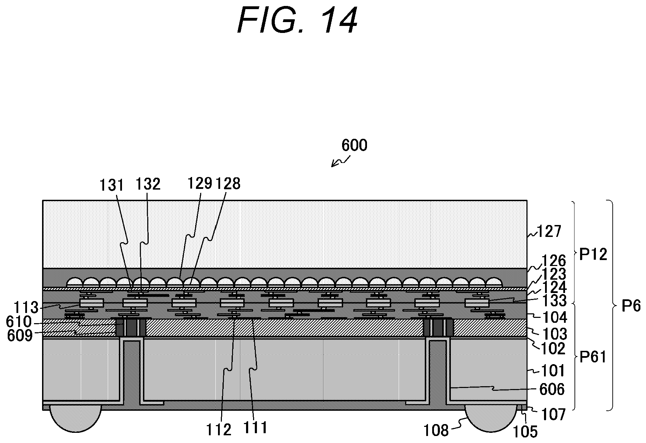

Fig. 14 is a diagram illustrating a configuration example of a semiconductor device according to the sixth embodiment.

In the drawing, a semiconductor device 600 includes a stacked chip P6 instead of the stacked chip P1 of the first embodiment described above. The stacked chip P6 includes a circuit chip P61 instead of the circuit chip P11 of the first embodiment described above. The other configurations of the semiconductor device 600 of the sixth embodiment are similar to those of the semiconductor device 100 of the first embodiment described above.

The circuit chip P61 includes a through electrode 606, a buried insulating layer 609, and a through via 610 instead of the through electrode 106, the buried insulating layer 109, and the through via 110 of the first embodiment described above. The through electrode 606, the buried insulating layer 609, and the through via 610 are arranged to overlap the effective pixel region. The buried insulating layer 609 is buried in the semiconductor substrate 103. The through via 610 extends through the buried insulating layer 609 to connect to the interconnect 111. The through electrode 606 extends through the support substrate 101 and the insulating layer 102 to connect to the through via 610. The other configurations of the circuit chip P61 of the sixth embodiment are similar to those of the circuit chip P11 of the first embodiment described above.

As described above, in the sixth embodiment, the through electrode 606 is formed in the support substrate 101 on which the semiconductor substrate 103 having the circuit layer formed thereon is stacked so as to overlap the effective pixel region. This configuration eliminates the need for providing the region where the through electrode 606 is arranged around the effective pixel region. It is therefore possible to reduce the peripheral region of the effective pixel region and thus reduce the chip size of the stacked chip P1.

Note that the structure in which the through electrode 606 is arranged to overlap the effective pixel region of the sixth embodiment described above may be applied to the semiconductor device of any of the second to fifth embodiments described above.

### <7. Seventh Embodiment>

In the first embodiment described above, the through electrode 106 is formed in the support substrate 101 on which the semiconductor substrate 103 having the circuit layer formed thereon is stacked. In this seventh embodiment, the through electrode 106 is formed in the support substrate 101 on which the semiconductor substrate 103 having the circuit layer formed thereon is stacked, and an open-end terminal is formed on the light-receiving surface side.

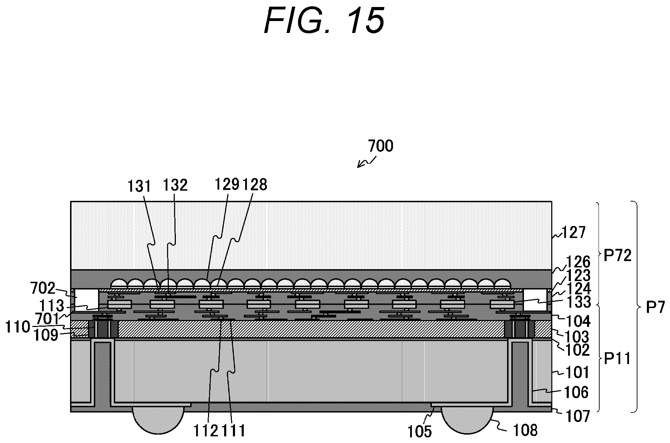

Fig. 15 is a diagram illustrating a configuration example of a semiconductor device according to the seventh embodiment.

In the drawing, a semiconductor device 700 includes a stacked chip P7 instead of the stacked chip P1 of the first embodiment described above. The stacked chip P7 includes a sensor chip P72 instead of the sensor chip P12 of the first embodiment described above. The other configurations of the semiconductor device 700 of the seventh embodiment are similar to those of the semiconductor device 100 of the first embodiment described above.

The sensor chip P72 is obtained by adding an open-end terminal 701 to the sensor chip P12 of the first embodiment described above. A pad electrode formed in the interconnect layer 104 can serve as the open-end terminal 701. On the open-end terminal 701, an opening 702 is formed. The opening 702 extends through the semiconductor substrate 123 and the interconnect layer 124 to allow the open-end terminal 701 to be exposed. The open-end terminal 701 can be arranged around the pixel region on the back surface side of the semiconductor substrate 123. Before the transparent substrate 127 is bonded to the semiconductor substrate 123, a test probe or pogo pin can be brought into contact with the open-end terminal 701 through the opening 702. The other configurations of the sensor chip P72 of the seventh embodiment are similar to those of the sensor chip P12 of the first embodiment described above.

As described above, in the seventh embodiment, the through electrode 106 is formed in the support substrate 101 on which the semiconductor substrate 103 having the circuit layer formed thereon is stacked, and the open-end terminal 701 is formed on the light-receiving surface side. With this configuration, after the process of c of Fig. 3, it is possible to electrically connect to the circuit layer formed on the semiconductor wafer 103W and the light-receiving layer formed on the semiconductor wafer 123W via the open-end terminal 701. It is therefore possible to test, before proceeding to the process subsequent to the process of c of Fig. 3, the circuit layer formed on the semiconductor wafer 103W and the light-receiving layer formed on the semiconductor wafer 123W.

Note that the structure in which the open-end terminal 701 is formed on the light-receiving surface side of the seventh embodiment described above may be applied to the semiconductor device of any of the second to sixth embodiments described above.

### <8. Eighth Embodiment>

In the first embodiment described above, the transparent substrate 127 is stacked on the light-receiving layer formed on the semiconductor substrate 123. In this eighth embodiment, a transparent layer having a thermal conductivity of at least 10 W/(m·k) is provided on the transparent substrate stacked on the light-receiving layer formed on the semiconductor substrate 123.

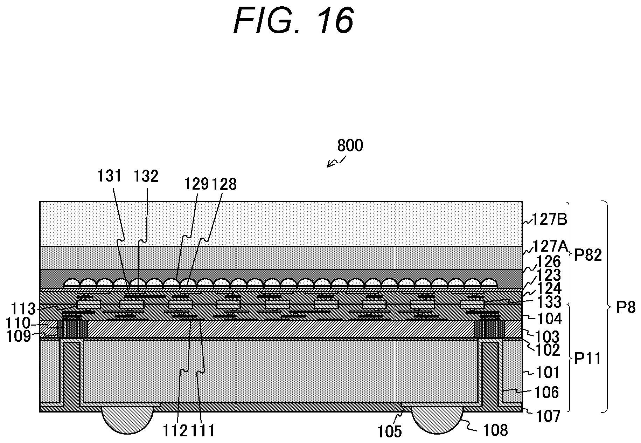

Fig. 16 is a diagram illustrating a configuration example of a semiconductor device according to the eighth embodiment.

In the drawing, a semiconductor device 800 includes a stacked chip P8 instead of the stacked chip P1 of the first embodiment described above. The stacked chip P8 includes a sensor chip P82 instead of the sensor chip P12 of the first embodiment described above. The other configurations of the semiconductor device 800 of the eighth embodiment are similar to those of the semiconductor device 100 of the first embodiment described above.

The sensor chip P82 includes a transparent layer 127A and a transparent substrate 127B instead of the transparent substrate 127 of the first embodiment described above. The transparent layer 127A and the transparent substrate 127B are stacked on one another. At this time, the transparent substrate 127B can be bonded to the adhesive layer 126 with the transparent layer 127A interposed therebetween. The thermal conductivity of the transparent layer 127A can be set higher than the thermal conductivity of the transparent substrate 127B. As the material of the transparent layer 127A, for example, a transparent material having a thermal conductivity of at least 10 W/(m·k) may be used. At this time, the material of the transparent layer 127A may be AlN, BN, or diamond. The transparent substrate 127B may be a glass substrate, a quartz substrate, or a transparent resin substrate such as acrylic or polycarbonate.

As described above, in the eighth embodiment, the transparent layer 127A having a thermal conductivity of at least 10 W/(m·k) is provided on the transparent substrate 127B stacked on the light-receiving layer formed on the semiconductor substrate 123. This configuration can improve heat dissipation from the semiconductor substrate 123 having the light-receiving layer formed thereon to the transparent substrate 127B and suppress a decrease in reliability while downsizing the stacked chip P8 on the basis of the WLCSP.

Note that, in the eighth embodiment described above, an example has been described in which the two-layer structure of the transparent layer 127A and the transparent substrate 127B is provided on the light-receiving layer formed on the semiconductor substrate 123. A structure in which at least two transparent layers having a thermal conductivity higher than that of the transparent substrate 127B are formed on the light-receiving layer formed on the semiconductor substrate 123 may be employed. Alternatively, the transparent substrate 127B may be removed, and only the transparent layer 127A may be used as a single layer.

Furthermore, the stacked structure of the transparent layer 127A and the transparent substrate 127B of the eighth embodiment described above may be applied to the semiconductor device of any of the first to seventh embodiments described above.

### <9. Ninth Embodiment>

In the first embodiment described above, the through electrode 106 is formed in the support substrate 101 on which the semiconductor substrate 103 having the circuit layer formed thereon is stacked, and the thermal conductivity of the support substrate 101 is set higher than the thermal conductivity of at least one of the semiconductor substrates 103 and 123. In this ninth embodiment, the through electrode 106 is formed in the support substrate 101 on which the semiconductor substrate 123 having the light-receiving layer formed thereon is stacked, and the thermal conductivity of the support substrate 101 is set higher than the thermal conductivity of at least one of the semiconductor substrates 103 and 123.

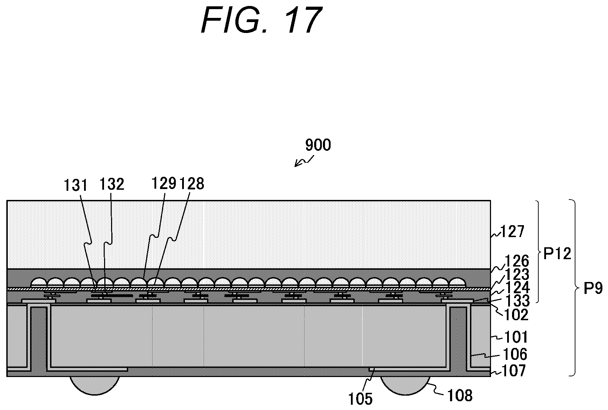

Fig. 17 is a diagram illustrating a configuration example of a semiconductor device according to the ninth embodiment.

In the drawing, a semiconductor device 900 includes a stacked chip P9 instead of the stacked chip P1 of the first embodiment described above. The stacked chip P9 includes the support substrate 101 and the sensor chip P12. The semiconductor substrate 103 and the interconnect layer 104 of the first embodiment described above are removed from the stacked chip P9. At this time, the sensor chip P12 is stacked on the support substrate 101 with the insulating layer 102 interposed therebetween. The through electrode 106 extends through the support substrate 101 and the insulating layer 102 to connect to the bonding electrode 133. Note that the insulating layer 102 may be omitted. The other configurations of the semiconductor device 900 of the ninth embodiment are similar to those of the semiconductor device 100 of the first embodiment described above.

As described above, in the ninth embodiment, the through electrode 106 is formed in the support substrate 101 on which the semiconductor substrate 123 having the light-receiving layer formed thereon is stacked, and the thermal conductivity of the support substrate 101 is set higher than the thermal conductivity of at least one of the semiconductor substrates 103 and 123. This configuration can improve heat dissipation from the semiconductor substrate 123 having the light-receiving layer formed thereon to the support substrate 101 and suppress a decrease in reliability while downsizing the stacked chip P9 on the basis of the WLCSP.

Note that, in the ninth embodiment described above, an example has been described in which the sensor chip P12 is stacked on the support substrate 101; alternatively, a stacked chip having a circuit chip stacked on the support substrate 101 may be used.

### <10. Tenth Embodiment>

In the first embodiment described above, the through electrode 106 is formed in the support substrate 101 on which the semiconductor substrate 103 having the circuit layer formed thereon is stacked, and the thermal conductivity of the support substrate 101 is set higher than the thermal conductivity of at least one of the semiconductor substrates 103 and 123. In this tenth embodiment, a semiconductor chip provided with a pixel array unit having pixels arranged in a matrix is stacked.

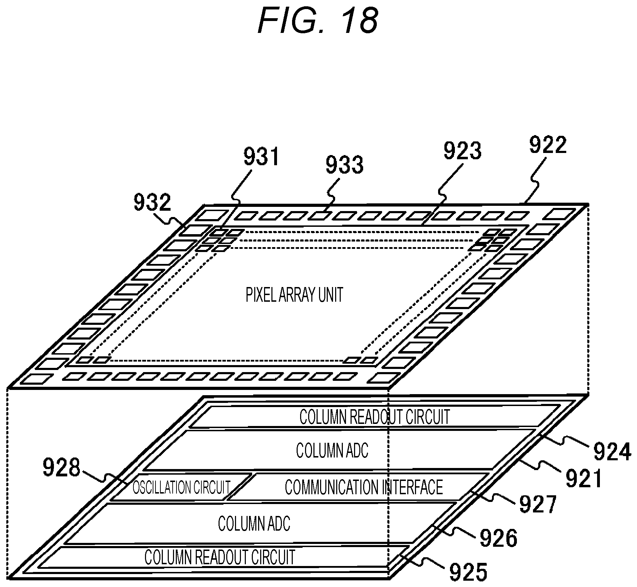

Fig. 18 is a perspective view illustrating an example of a stacked pixel array unit according to the tenth embodiment.

In the drawing, a solid-state imaging device includes semiconductor chips 921 and 922. The semiconductor chip 922 is stacked on the semiconductor chip 921.

A pixel array unit 923 is formed on the semiconductor chip 922. The pixel array unit 923 includes pixels 931 arranged in a matrix in the row direction and the column direction. A pad electrode 932 and a via electrode 933 are formed around the pixel array unit 923. The via electrode 933 extends through the semiconductor chip 922 to electrically connect the semiconductor chips 921 and 922 to each other. Note that the sensor chip of any of the first to eighth embodiments described above may be applied to the semiconductor chip 922.

A peripheral circuit 924 is formed on the semiconductor chip 921. In the peripheral circuit 924, a column readout circuit 925, a column ADC 926, a communication interface 927, and an oscillation circuit 928 are formed. The column readout circuit 925 and the column ADC 926 may be formed so as to correspond to positions on both sides of the pixel array unit 923 in the column direction. Note that the circuit chip of any of the first to eighth embodiments described above may be applied to the semiconductor chip 921.

The semiconductor chips 921 and 922 may be directly bonded. For the direct bonding between the semiconductor chips 921 and 922, hybrid bonding can be used. At this time, the semiconductor chips 921 and 922 may be electrically connected on the basis of Cu-Cu connection. Examples of the materials of semiconductor substrates used for the semiconductor chips 921 and 922 may include Si, InGaAs, and InP.

As described above, in the tenth embodiment described above, the semiconductor chip 922 having the pixel array unit 923 formed thereon is stacked on the semiconductor chip 921 having the peripheral circuit 924 formed thereon. This configuration can increase the sensitivity of the solid-state imaging device while suppressing an increase in mounting area of the semiconductor chip on which the solid-state imaging device is formed.

### <11. Application Examples to Mobile Object>

The technology according to the present disclosure (present technology) can be applied to various products. For example, the technology according to the present disclosure may be implemented as a device mounted on any type of mobile object such as an automobile, an electric vehicle, a hybrid electric vehicle, a motorcycle, a bicycle, a personal mobility, an airplane, a drone, a vessel, a robot, and the like.

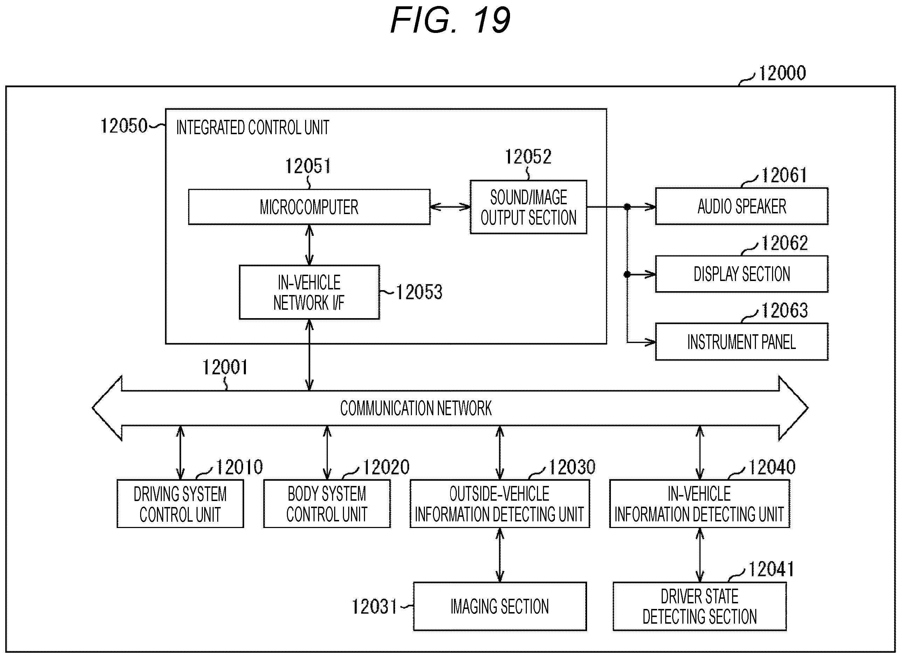

Fig. 19 is a block diagram illustrating a schematic configuration example of a vehicle control system which is an example of a mobile object control system to which the technology according to the present disclosure can be applied.

The vehicle control system 12000 includes a plurality of electronic control units connected to each other via a communication network 12001. In the example illustrated in Fig. 19, the vehicle control system 12000 includes a driving system control unit 12010, a body system control unit 12020, an outside-vehicle information detecting unit 12030, an in-vehicle information detecting unit 12040, and an integrated control unit 12050. Furthermore, a microcomputer 12051, a sound/image output section 12052, and an in-vehicle network interface (I/F) 12053 are illustrated as functional components of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. Furthermore, the light received by the imaging section 12031 may be visible light, or may be invisible light such as infrared rays.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example illustrated in Fig. 19, as the output device, an audio speaker 12061, a display section 12062, and an instrument panel 12063 are illustrated. The display section 12062 may, for example, include at least one of an on-board display and a head-up display.

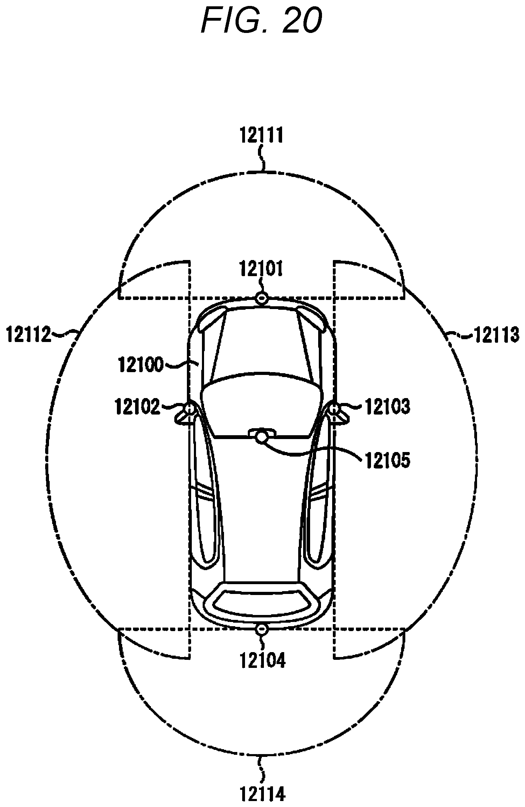

Fig. 20 is a diagram illustrating an example of the installation position of the imaging section 12031.

In Fig. 20, the imaging section 12031 includes imaging sections 12101, 12102, 12103, 12104, and 12105.

The imaging sections 12101, 12102, 12103, 12104, 12105 are provided at positions such as a front nose, sideview mirrors, a rear bumper, a back door, and an upper portion of a windshield in the interior of the vehicle 12100. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly images of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Note that Fig. 20 illustrates an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

In the above, an example has been described of the vehicle control system to which the technology according to the present disclosure can be applied. The technology of the present disclosure can be applied to the imaging section 12031 among the components described above. Specifically, for example, the semiconductor devices of the above-described embodiments can be applied to the imaging section 12031. By applying the technology according to the present disclosure to the vehicle control system 12000, it is possible to improve reliability while downsizing the imaging section 12031.

Note that the above-described embodiments are examples for embodying the present technology, and the matters in the embodiments and the matters defining the invention in the claims have correspondence relationships. Similarly, the matters defining the invention in the claims and matters with the same names in the embodiments of the present technology have correspondence relationships. The present technology, however, is not limited to the embodiments, and can be embodied by making various modifications to the embodiments without departing from the gist of the present technology. Furthermore, effects described herein are merely examples and are not intended to be limiting, and other effects may be provided.

Note that the present technology may also have the following configurations.
(1) A semiconductor device including:
   a first semiconductor substrate having at least one of a light-receiving layer or a circuit layer formed thereon;
   a support substrate on which the first semiconductor substrate is stacked, the support substrate having a thermal conductivity higher than a thermal conductivity of the first semiconductor substrate; and
   a through electrode extending through the support substrate to electrically connect to the first semiconductor substrate.
(2) The semiconductor device according to the above (1), in which
   the support substrate has an electrical conductivity lower than an electrical conductivity of the first semiconductor substrate.
(3) The semiconductor device according to the above (1) or (2), in which
   the support substrate includes an insulating substrate or a semi-insulating substrate.
(4) The semiconductor device according to the above (3), in which
   a material of the insulating substrate includes AlN, BN, or diamond.
(5) The semiconductor device according to the above (3), in which
   a material of the semi-insulating substrate includes GaAs, GaN, or SiC.
(6) The semiconductor device according to any one of the above (1) to (5), in which
   the thermal conductivity of the support substrate is greater than or equal to 150 W/(m·k).
(7) The semiconductor device according to any one of the above (1) to (6), further including:
   a second semiconductor substrate having a circuit layer formed thereon, the first semiconductor substrate being stacked on the second semiconductor substrate; and
   an interconnect layer provided between the first semiconductor substrate and the second semiconductor substrate, in which
   the second semiconductor substrate is stacked on the support substrate, and
   the through electrode is electrically connected to the interconnect layer.
(8) The semiconductor device according to the above (7), further including:
   a through via extending through the second semiconductor substrate to connect the through electrode and the interconnect layer; and
   a buried insulating layer buried in the second semiconductor substrate to insulate the through via from the second semiconductor substrate.
(9) The semiconductor device according to the above (7) or (8), in which
   the second semiconductor substrate and the support substrate are configured by a silicon on insulator (SOI) substrate.
(10) The semiconductor device according to any one of the above (7) to (9), further including:
   an insulating layer provided between the second semiconductor substrate and the support substrate, the insulating layer including a material different from a material of the support substrate.
(11) The semiconductor device according to any one of the above (7) to (10), further including:
   a redistribution interconnect formed on a back surface of the support substrate; and
   a recess or a protrusion formed in a region of the back surface of the support substrate that is not covered with the redistribution interconnect.
(12) The semiconductor device according to any one of the above (7) to (11), further including:
   an effective pixel region in which pixels having the light-receiving layer formed thereon are arranged in a matrix in a row direction and a column direction, in which
   at least a part of the through electrode is arranged to overlap the effective pixel region.
(13) The semiconductor device according to any one of the above (7) to (12), in which
   the first semiconductor substrate, the second semiconductor substrate, and the support substrate are packaged on the basis of a wafer level chip size package (WLCSP).
(14) The semiconductor device according to any one of the above (1) to (13), further including:
   an open-end terminal formed on a light-receiving surface side of the first semiconductor substrate.
(15) A semiconductor device including:
   a semiconductor substrate having a light-receiving layer formed thereon; and
   a transparent substrate stacked on the semiconductor substrate, the transparent substrate being provided with a transparent layer having a thermal conductivity of at least 10 W/(m·k).
(16) The semiconductor device according to the above (15), in which
   a material of the transparent layer includes AlN, BN, or diamond.
(17) The semiconductor device according to the above (15) or (16), further including:
   a light-shielding film provided on a side surface of the transparent substrate, the light-shielding film having a thermal conductivity of at least 10 W/(m·k).
(18) The semiconductor device according to the above (17), in which
   a material of the light-shielding film includes a carbon nanotube.
(19) The semiconductor device according to any one of the above (15) to (18), further including:
   an on-chip lens formed on the light-receiving layer, the on-chip lens having a thermal conductivity of at least 10 W/(m·k) and a refractive index of at least 1.7.
(20) The semiconductor device according to any one of the above (15) to (19), in which
   the semiconductor substrate and the transparent substrate are packaged on the basis of a WLCSP.

### REFERENCE SIGNS LIST

100 Semiconductor device
P1 Stacked chip
P11 Circuit chip
P12 Sensor chip
101 Support substrate
102, 107 Insulating layer
103, 123 Semiconductor substrate
104, 124 Interconnect layer
105 Redistribution interconnect
106 Through electrode
108 Bump electrode
109 Buried insulating layer
110 Through via
111, 131 Interconnect
112, 132 Via
113, 133 Bonding electrode
126 Adhesive layer
127 Transparent substrate
128 Color filter
129 On-chip lens

## Claims

1. A semiconductor device comprising:
a first semiconductor substrate having at least one of a light-receiving layer or a circuit layer formed thereon;
a support substrate on which the first semiconductor substrate is stacked, the support substrate having a thermal conductivity higher than a thermal conductivity of the first semiconductor substrate; and
a through electrode extending through the support substrate to electrically connect to the first semiconductor substrate.

2. The semiconductor device according to claim 1, wherein
the support substrate has an electrical conductivity lower than an electrical conductivity of the first semiconductor substrate.

3. The semiconductor device according to claim 1, wherein
the support substrate includes an insulating substrate or a semi-insulating substrate.

4. The semiconductor device according to claim 3, wherein
a material of the insulating substrate includes AlN, BN, or diamond.

5. The semiconductor device according to claim 3, wherein
a material of the semi-insulating substrate includes GaAs, GaN, or SiC.

6. The semiconductor device according to claim 1, wherein
the thermal conductivity of the support substrate is greater than or equal to 150 W/(m·k).

7. The semiconductor device according to claim 1, further comprising:
a second semiconductor substrate having a circuit layer formed thereon, the first semiconductor substrate being stacked on the second semiconductor substrate; and
an interconnect layer provided between the first semiconductor substrate and the second semiconductor substrate, wherein
the second semiconductor substrate is stacked on the support substrate, and
the through electrode is electrically connected to the interconnect layer.

8. The semiconductor device according to claim 7, further comprising:
a through via extending through the second semiconductor substrate to connect the through electrode and the interconnect layer; and
a buried insulating layer buried in the second semiconductor substrate to insulate the through via from the second semiconductor substrate.

9. The semiconductor device according to claim 7, wherein
the second semiconductor substrate and the support substrate are configured by a silicon on insulator (SOI) substrate.

10. The semiconductor device according to claim 7, further comprising:
an insulating layer provided between the second semiconductor substrate and the support substrate, the insulating layer including a material different from a material of the support substrate.

11. The semiconductor device according to claim 7, further comprising:
a redistribution interconnect formed on a back surface of the support substrate; and
a recess or a protrusion formed in a region of the back surface of the support substrate that is not covered with the redistribution interconnect.

12. The semiconductor device according to claim 7, further comprising:
an effective pixel region in which pixels having the light-receiving layer formed thereon are arranged in a matrix in a row direction and a column direction, wherein
at least a part of the through electrode is arranged to overlap the effective pixel region.

13. The semiconductor device according to claim 7, wherein
the first semiconductor substrate, the second semiconductor substrate, and the support substrate are packaged on a basis of a wafer level chip size package (WLCSP).

14. The semiconductor device according to claim 1, further comprising:
an open-end terminal formed on a light-receiving surface side of the first semiconductor substrate.

15. A semiconductor device comprising:
a semiconductor substrate having a light-receiving layer formed thereon; and
a transparent substrate stacked on the semiconductor substrate, the transparent substrate being provided with a transparent layer having a thermal conductivity of at least 10 W/(m·k).

16. The semiconductor device according to claim 15, wherein
a material of the transparent layer includes AlN, BN, or diamond.

17. The semiconductor device according to claim 15, further comprising:
a light-shielding film provided on a side surface of the transparent substrate, the light-shielding film having a thermal conductivity of at least 10 W/(m·k).

18. The semiconductor device according to claim 17, wherein
a material of the light-shielding film includes a carbon nanotube.

19. The semiconductor device according to claim 15, further comprising:
an on-chip lens formed on the light-receiving layer, the on-chip lens having a thermal conductivity of at least 10 W/(m·k) and a refractive index of at least 1.7.

20. The semiconductor device according to claim 15, wherein
the semiconductor substrate and the transparent substrate are packaged on a basis of a WLCSP.
